# EUROPEAN PATENT APPLICATION

(11) **EP 3 197 022 A1**
(43) Date of publication of application: **26.07.2017**
(21) Application number: 16152012.7
(22) Date of filing: 20.01.2016
(51) Int. Cl.: H02K 5/128, H02K 15/14, C23C 14/04, C23C 14/06

(54) **METHOD FOR PRODUCING A CAN FOR AN ELECTRIC MOTOR**

(71) Applicant: Siemens Aktiengesellschaft, 80333 München (DE)
(72) Inventor: Schoeman, Chiel, 7443 NC Nijverdal (NL)

(57) **Abstract**

The invention relates to a method for producing a can (40) for an electric motor (34). A can (40) with enhanced corrosion resistance may be achieved in that a hollow cylinder (2) is coated at least partially with a coating (44) by means of a vapour deposition method, wherein the hollow cylinder (2) provided with the coating (44) forms the can (40).

## Description

The invention relates to a method for producing a can for an electric motor.

An electric motor comprising a can is known from prior art, for instance from WO 2004/036052 A1, and is particularly used in a hermetically sealed compressor unit. The can, also called stator-can, has a tubular shape and is arranged in the gap between a rotor and a stator of the electric motor. The function of the can is to ensure that a gas, which is used as a working fluid in the compressor unit, will not reach the stator of the electric motor, where it could damage/degrade the stator.

The gas, which is used as a working fluid in the compressor unit and partially flows through the can, is normally harmful and/or corrosive. Due to the contact between the gas and the can, the gas attacks the can and the can degrades over time. The more the can degrades the more probable it is that the can fails and/or gets a damaged, for example by getting permeable for gas. Damage of the can has to be avoided, since the can has the function to keep the gas away from the stator. Accordingly, a damaged can will cause a machine downtime and/or a damage of the electric motor.

One objective of the invention is to provide a method for producing a can for an electric motor with enhanced chemical degradation resistance and permeation resistance.

This objective is accomplished by means of a method according to claim 1. In the method for producing a can for an electric motor, according to the invention, a hollow cylinder is coated at least partially with a coating by means of a vapour deposition method and the hollow cylinder provided with the coating forms the can.

The invention is based on the finding that a coating may protect the can from a harmful and/or corrosive gas. Advantageously, the coating prevents the can to degrade. Hence, the coating may prevent the can from getting a damage and/or from failing. Accordingly, permeation of gas through the can may be avoided. Thus, machine downtimes and damages of the electric motor may be avoided.

Employing a vapour deposition method allows for achieving a coating having a good adhesion to the hollow cylinder, particularly to a surface of the hollow cylinder. As a further advantage, the vapour deposition method allows to coat a large area of the hollow cylinder. Also the coating may selectively cover specified regions of the hollow cylinder. Moreover, the vapour deposition method allows for achieving a homogenous coating, where the coating thickness varies, for example, less than ±10%, preferably less than ±5%.

A vapour deposition method in the meaning of this invention may be a deposition method, wherein the deposition takes place from the gas phase or rather from the vapour phase.

Advantageously, the hollow cylinder is a composite tube. Preferentially, the composite tube comprises at least one fibre. For instance, the hollow cylinder may be a fibre reinforced composite tube. Particularly, the hollow cylinder can consist of at least one fibre, e.g. a glass fibre, embedded in a hardened matrix. Further, the hardened matrix may be epoxy resin. If necessary, the hollow cylinder can have a layer of carbon threads embedded in the hardened matrix.

Expediently, the coating is gas-tight, particularly gas-tight in respect to the gas used as a working fluid in the compressor unit. A gas-tight coating within the meaning of this invention may also include that diffusion through the coating is prevented. Hence, permeation of gas through the can may be reduced and/or avoided.

Since epoxy resin is not completely gas-tight with respect to pressure differentials and has a low diffusion barrier - so that gas can penetrate through the hollow cylinder towards the stator due to high pressure differentials and/or due to diffusion - the coating will enhance the gas-tight properties of the can. Also, the coating may minimise or even prevent the permeation of gas through the can.

Expediently, the coating is chemically inert. Thus, the coating can have a high chemical degradation resistance. For instance, the coating can be chemically inert to water moisture, carbon dioxide, hydrogen sulphide and/or other chemicals. Thus, this chemicals may not attack and/or degrade the coating. Advantageously the coating will enhance the chemical degradation resistance of the can.

It may be achieved, that a strength/stiffness of the can is kept constant over the lifetime of the can. Further a glass transition temperature of the can may kept constant over the lifetime of the can. In this way, less degradation of the can may take place. Thus, the ability of the can keeping gas away from the stator may be preserved. Following, the can may have less failures and/or the electric motor comprising such a can may have less machine downtime.

Preferably, the inner surface of the hollow cylinder, also called inner side of the hollow cylinder, is coated. Preferably, the inner surface of the hollow cylinder is coated completely. Expediently, the gas will not degrade/damage the can due to the coating at the inner surface of the hollow cylinder. Further it is advantageous, if the coating prevents or minimises permeation of the gas through the can (towards the stator).

Optionally, the outer surface of the can may be coated. Thus, permeation through the can may be reduced even more.

It is preferred, if the coating is applied only to the inner surface of the can. In this way, this allows for - in the case gas nethertheless permeates through the coating - gas may be released through an outer surface of the can and is not trapped inside the can. If the gas would be trapped inside the can, the gas could attack and/or damage the hollow cylinder.

Furthermore, it is advantageous, if the coating is electrically insulating or - in other words - if the coating is nonconductive. It is preferred, if the electric resistivity of the coating is at least 10⁴ Ωm, especially at least 10⁶ Ωm.

Advantageously, a coating thickness of the coating is at least 0.2 µm, especially at least 2 µm. If this coating thickness is applied, the coating may serve as a water barrier. Moreover it is preferred, that the coating thickness of the coating is at most 250 µm, especially at most 100 µm.

Further it is advantageous, if a microhardness of the coating is at least 5 GPa, especially at least 10 GPa. The micro-hardeness may be a hardness determined by a microindentation hardness testing method. Moreover it is preferred, if a Rockwell hardness of the coating is at least HRC 50, especially at least HRC 65. Furthermore, a coefficient of friction of the coating may be at most 0.5, especially at most 0.2.

The mentioned microhardness of the coating, the mentioned Rockwell hardness of the coating and/or the mentioned coefficient of friction of the coating may minimise or even prevent erosion of the can caused by particles in the gas and/or may minimise or even prevent adsorption of the particles at the can. Further, the mentioned microhardness of the coating, the mentioned Rockwell hardness of the coating and/or the mentioned coefficient of friction of the coating may result in beneficial erosion properties (that is, if erosion may be reduced) of the coating and/or good anti fouling properties of the coating. In this way, the coating may enhance the resistance to erosion of the can.

In a preferred embodiment of the invention, the coating is a diamond-like carbon coating. The diamond-like carbon coating is a coating which contains carbon, especially amorphous carbon. At least some of the carbon atoms may be sp³ hybridised. The remaining part of the carbon atoms may be sp² hybridised. Moreover, the diamond-like carbon coating may contain a filler, particularly hydrogen. For example, the fraction of hydrogen atoms in the diamond-like carbon coating may be 0 at% to 80 at%.

The coating is called diamond-like, because its structure, which is non-crystalline, may have features (especially sp³ hybridised carbon atoms) which are similar to the diamond crystal structure. Further the coating is called diamond-like, because its hardness has higher values than most common materials, especially its microhardness is at least 8 GPa and/or its Rockwell hardness is at least HRC 64.

Further in an advantageous embodiment of the invention, the coating is a diamond-like hybrid material coating, also called diamond-like nanocomposite coating. A hybrid material in the meaning of this invention may be a composite consisting of two constituents at the molecular level. A diamond-like hybrid material coating may be interpreted as diamond-like carbon coating with an (additional) filler. Thus, the diamond-like hybrid material coating may contain a filler, especially silicon and/or oxide. The advantage of the filler in the diamond-like hybrid material coating is, that it may increase electrical resistivity of the coating, may increase temperature stability of the coating, may reduce the friction coefficient of the coating and/or may reduce internal stress within the coating.

In another preferred embodiment of the invention, the coating contains silicon oxide, particularly silicon dioxide. For instance, the coating may basically solely consist of silicon oxide, particularly of silicon dioxide. Especially, the coating may be a quartz-like silicon oxide coating.

In a further advantageous embodiment of the invention, the coating contains Parylene. For instance, the coating may basically solely consists of Parylene. Parylene in the meaning of the invention may be a poly(p-xylylene) polymer, which may contain hydrogen and/or halogen(s). There are several types of Parylenes, for instance Parylene N, Parylene X, Parylene C, Parylene D, Parylene HT, Parylene SF and Parylene AF-4. The phrase Parylene is used for any of these types or for a mixture of these types.

Advantageously, the coating is free from pinholes. Expediently, the coating is a barrier for water moisture, carbon dioxide, hydrogen sulphide and/or other chemicals. Furthermore, the coating can be thermally stable up to 300 °C and/or may be UV stable.

Preferably, the vapour deposition method is a chemical vapour deposition method. For example, the vapour deposition method can be a low pressure chemical vapour deposition method, a plasma enhanced chemical vapour deposition method (also called plasma assisted chemical vapour deposition method), an atomic layer deposition method and/or a molecular layer deposition method.

During the vapour deposition, a gas supply may be situated at one or both end(s) of the can and/or inside the can. The gas supply may be a gas lance, particularly comprising one or several orifices, particularly one or several nozzles. Further, at least one electrode may be placed inside the can, especially to produce a plasma. The gas supply and/or the electrode may be movable and/or rotatable. During the vapour deposition, the can may be at rest and/or may rotate.

Furthermore, the vapour deposition method may be a physical vapour deposition method. For example, the vapour deposition method can be an evaporative deposition method, particularly a thermal evaporation method. Further the vapour deposition method may for example be a cathodic arc deposition method, a sputter deposition method and/or an ion beam deposition method. A material to be evaporated/vaporised by means of the physical vapour deposition method may be situated at one or both end(s) of the can and/or inside the can.

Further it is preferred, if the gas temperature during the vapour deposition is at most 220 °C, preferably at most 200 °C. In case of plasma the gas temperature may be the temperature of neutral gas and/or of ions. By employing one of the aforementioned deposition methods, such gas temperature can be observed easily. The pressure during vapour deposition may be between at least 0.01 mbar, especially at least 0.1 mbar, and at most 5 mbar, especially at most 1 mbar.

Principally, the deposition could be a multi-stage process, e.g. a two-stage process. In that case, a first coating may be deposited with a first vapour deposition method and afterwards a second coating may be deposited with a second vapour deposition method. The first and the second vapour deposition method each may be one of the vapour deposition methods described above. Further, the first coating may be the first mentioned coating.

Thus, the hollow cylinder could comprise a second coating on top of the first mentioned coating. The second coating could be produced by one of the methods described above.

Further the invention relates to a can for an electric motor produced by a method described above.

Thus, the invention also relates to a can for an electric motor comprising a hollow cylinder at least partially provided with a coating produced by means of a vapour deposition method. Features, which are mentioned above (in connection with the method) may also refer the last mentioned can.

Further the invention relates to a compressor unit. The compressor unit may comprise a compressor. Moreover, the compressor unit may comprise an electric motor for driving the compressor. Furthermore, the compressor unit may comprise a stator and a rotor. Advantageously, the compressor unit may comprise a can according to the previous description. Prefferentially, the can is placed between the rotor and the stator of the electric motor. Preferably, the compressor unit is a hermetically sealed compressor unit. A hermetically sealed compressor unit may be interpreted as a compressor unit with a common gas-tight housing for its components.

Even if terms are used in the singular or in a specific numeral form, the scope of the invention should not be restricted to the singular or the specific numeral form.

The previously given description of advantageous embodiments of the invention contains numerous features which are partially combined with one another in the dependent claims. Expediently, these features can also be considered individually and be combined with one another into further suitable combinations. More particularly, these features may be combined with the can and the method according to the respective independent claim individually as well as in any suitable combination. Furthermore, features of the method, formulated as apparatus features, may be considered as features of the can and, accordingly, features of the can, formulated as process features, may be considered as features of the method.

The above-described characteristics, features and advantages of the invention and the manner in which they are achieved can be understood more clearly in connection with the following description of exemplary embodiments which will be explained with reference to the drawings. The exemplary embodiments are intended to illustrate the invention, but are not supposed to restrict the scope of the invention to combinations of features given therein, neither with regard to functional features. Furthermore, suitable features of each of the exemplary embodiments can also be explicitly considered in isolation, be removed from one of the exemplary embodiments, be introduced into another of the exemplary embodiments and/or be combined with any of the appended claims.

In the drawings display:
- FIG 1: a schematic overview of coating a hollow cylinder by means of low pressure chemical vapour deposition;
- FIG 2: a schematic overview of coating a hollow cylinder by means of plasma enhanced chemical vapour deposition;
- FIG 3: a schematic overview of coating a hollow cylinder by means of physical vapour deposition;
- FIG 4: a schematic overview of a compressor unit; and
- FIG 5: a can for an electric motor.

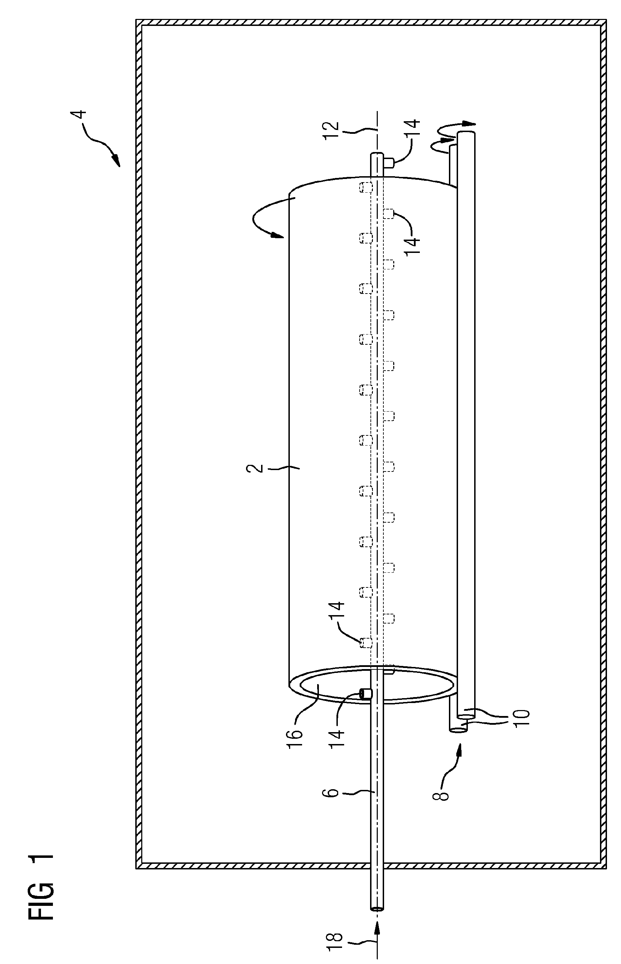

FIG 1 schematically shows a hollow cylinder 2 in a reactor chamber 4. The hollow cylinder 2 is a coiled glass fibre embedded in epoxy resin. Thus, the hollow cylinder 2 is a fibre reinforced composite tube. The reactor chamber 4 comprises a gas supply 6 and a support 8, wherein the support 8 comprises two rolls 10. Further, the hollow cylinder 2 is arranged on the rolls 10. Moreover, the hollow cylinder 2 and the gas supply 6 are arranged on a common axis 12.

The gas supply 6 is situated inside the hollow cylinder 2. Further, the gas supply 6 is formed like a gas lance and comprises several orifices 14. The orifices 14 or most of them are placed at the inside of the hollow cylinder 2 and point towards the inner surface 16 of the hollow cylinder 2. In this exemplary embodiment, the orifices 14 point in two directions (up and down according to the drawing). Alternatively, the orifices 14 could also point in only one direction or in more than two directions.

In this embodiment the orifices 14 of the gas supply 6 are formed like nozzles. Optionally, the orifices 14 can be individually switched on / switched off.

A chemical vapour deposition method, particularly a low pressure chemical vapour deposition method, is used to coat the hollow cylinder 2, particularly as described below.

A vacuum is created in the reactor chamber 4. Particularly, the pressure created in the reactor chamber 4 is 0.1 mbar. Further, a reacting gas 18 is induced into the reactor chamber 4 via the gas supply 6. The reacting gas adsorbs at the surface of the hollow cylinder 2. Besides, a reaction, for instance a polymerisation, takes place at the surface of the hollow cylinder 2 and the hollow cylinder 2 is coated. The gas temperature during the low pressure vapour deposition is in the ambient range, particularly 20 °C to 40 °C.

Due to the shape and the arrangement of the gas supply 6, only or mostly the inner surface 16 of the hollow cylinder 2 is coated. Especially, the inner surface 16 of the hollow cylinder 2 is coated completely. During the coating, the rolls 10 are driven by a motor (not shown) and rotate. Since the hollow cylinder 2 is placed on the rolls 10, also the hollow cylinder 2 rotates during the coating. Thus, an uniform and homogenous coating is applied. The direction of rotation is indicated by arrows in the drawing.

Different coatings can be supplied by means of the described low pressure chemical vapour deposition method. The coating, which will be deposited, depends on the used reacting gas 18.

For example, the reacting gas 18 may be p-Xylol or a halogenated derivate of p-Xylol to build up a Parylene coating. Thus, the coating may be a Parylene coating. Particularly, the reacting gas 18 may be p-Xylol to build up a Parylene N coating.

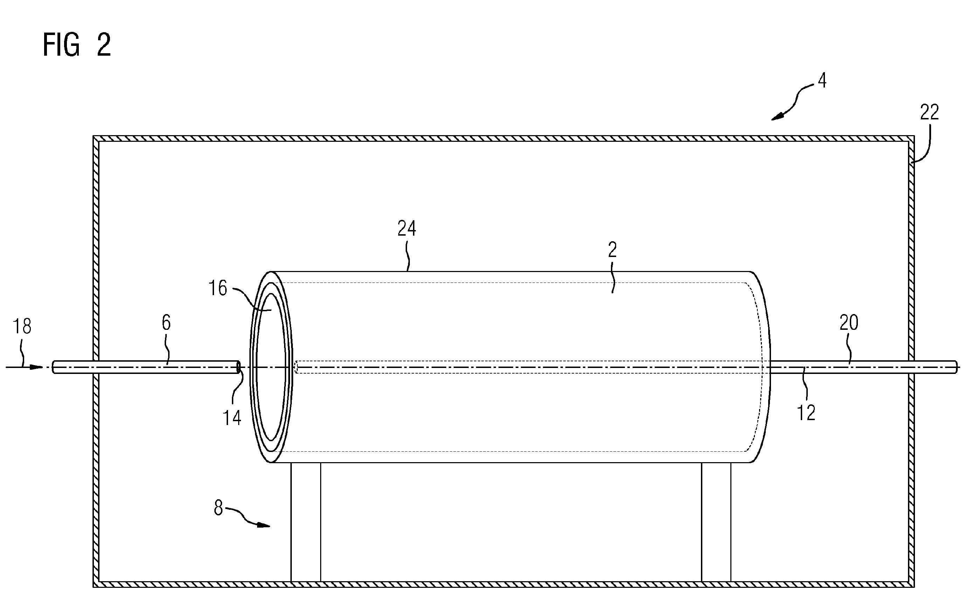

FIG 2 shows schematically an analogous hollow cylinder 2 in a different reactor chamber 4. The following description is restricted essentially to the differences from the embodiment of FIG 1, to which is referred regarding unchanged features and functions. Essentially identical elements are generally denoted by the same reference numbers and not mentioned features are included in the following embodiment without being described again.

The reactor chamber 4 comprises an electrode 20 and conductive walls 22. The gas supply 6 is shaped like a gas lance with one orifice 14 at the end. The orifice 14 of the gas supply 6 is situated at one end of the hollow cylinder 2. Further, the hollow cylinder 2, the gas supply 6 as well as the electrode 20 are arranged on a common axis 12.

A removable tube 24 is arranged around the hollow cylinder 2. The removable tube is arranged on a support 8 and rests.

A chemical vapour deposition method, particularly a plasma enhanced chemical vapour deposition method, is used to coat the hollow cylinder 2, particularly as described below.

A vacuum is created in the reactor chamber 4. Particularly, the pressure created in the reactor chamber 4 is 1 mbar. Further, a reacting gas 18 is induced into the reactor chamber 4 via the gas supply 6. Optionally, the reactor chamber could comprise more than one gas supply and the reacting gas could be induced into the reactor chamber via all gas supplies. Thus, particularly different components of the reacting gas could be induced into the reactor chamber separately.

An alternating current is applied between the electrode 20 and the conductive walls 22. Particularly, the frequency of the alternating current is in the range of radio frequency. Thus, a plasma is produced inside the hollow cylinder 2. Hence, some atoms and/or molecules of the reacting gas 18 get ionised and partially will be deposited to the inner surface 16 of the hollow cylinder 2. The gas temperature during the plasma enhanced vapour deposition is in the range 150 °C to 200 °C.

Alternatively, the plasma could also be produced outside the reactor chamber and the produced plasma could be introduced into the reactor chamber.

The inner surface 16 of the hollow cylinder 2 is coated completely. To ensure, that the outer surface 50 of the hollow cylinder 2 will remain uncoated, the removable tube 24 is arranged around the hollow cylinder 2. For instance, the hollow cylinder 2 can be shoved into the / out of the removable tube 24. Alternatively, the removable tube 24 can be opened to insert and/or remove the hollow cylinder 2. In this embodiment the hollow cylinder 2 rests during the coating (in contrast to FIG 1). Principally, it would be possible that the hollow cylinder rotates during the coating analogous to FIG 1.

Different coatings can be supplied by means of the described plasma enhanced chemical vapour deposition method. The coating, which will be deposited, depends on the used reacting gas 18.

For example the reacting gas 18 may be a combination of a silicon precursor gas and an oxygen precursor gas to build up a silicon dioxide coating. The silicon precursor gas may be for instance dichlorsilan, silane or tetraethoxysilane. Further, the oxygen precursor gas may be for instance oxygen or nitrous oxide. Thus, the coating may be a silicon dioxide coating, particularly SiO₂.

As a further example, the reacting gas 18 may be a carbon precursor gas, optionally together with a filler gas, to build up a diamond-like carbon coating. The carbon precursor gas may be for instance methane or acetylene. The filler gas may be for instance hydrogen. Thus, the coating may be a diamond-like carbon coating, particularly a-C:H.

As another example, the reacting gas 18 may be a combination of a carbon precursor gas and a filler gas, wherein the filler gas contains a silicon precursor gas to build up a diamond-like hybrid material coating. Thus, the coating may be a diamond-like hybrid material coating, particularly a-C:H/a-Si:O.

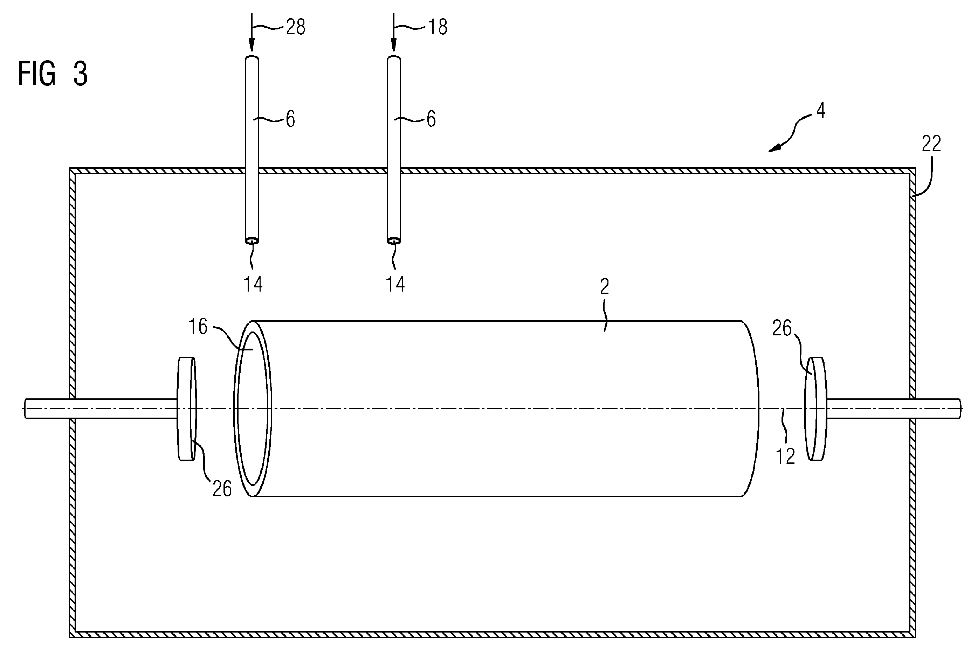

FIG 3 schematically shows an analogous hollow cylinder 2 in a different reactor chamber 4. The following description is restricted essentially to the differences from the embodiment of FIG 2, to which is referred regarding unchanged features and functions. Essentially identical elements are generally denoted by the same reference numbers and not mentioned features are included in the following embodiment without being described again.

The reactor chamber 4 comprises two sputter targets 26. Further, the hollow cylinder 2 and the two sputter targets 26 are arranged on a common axis 12. Furthermore, the reactor chamber 4 comprises two gas supplies 6, which are situated perpendicular to the common axis 12. The first gas supply 6 is a gas supply 6 for a sputter gas 28. The second (optional) gas supply 6 is a gas supply 6 for a reacting gas 18.

Further, the reactor chamber 4 may comprise a support (not shown), especially analogous to the support shown in FIG 1 or FIG 2.

A physical vapour deposition method, particularly a sputter deposition method, is used to coat the hollow cylinder 2, particularly as described below.

A vacuum is created in the reactor chamber 4. Particularly, the pressure created in the reactor chamber 4 is 1 mbar. Further, a sputter gas 28 is induced into the reactor chamber 4 via the gas supply 6. The sputter gas 28 comprises positive ions, particularly positive argon ions (Ar⁺). The sputter target 26 gets charged negatively and/or a magnetic field is applied to the sputter target 26, where the sputter gas 28 gets trapped. Accordingly, the sputter gas 28 sputters the sputter target 26, so that atoms of the sputter target 26 are removed from the sputter target 26. The removed atoms from the sputter target 26 may react with the reacting gas and are deposited at the hollow cylinder 2. The gas temperature of the deposited gas during the sputter deposition is at least 200 °C.

Different coatings can be supplied by means of the described sputter deposition method. The coating, which will be deposited, depends mainly on the used sputter target 26.

For example, the sputter target 26 may be a carbon target, especially a graphite target, to build up a diamond-like carbon coating. Further the reacting gas 18 may be hydrogen to build up a diamond-like carbon coating. Thus, the coating may be a diamond-like carbon coating, particularly a-C:H.

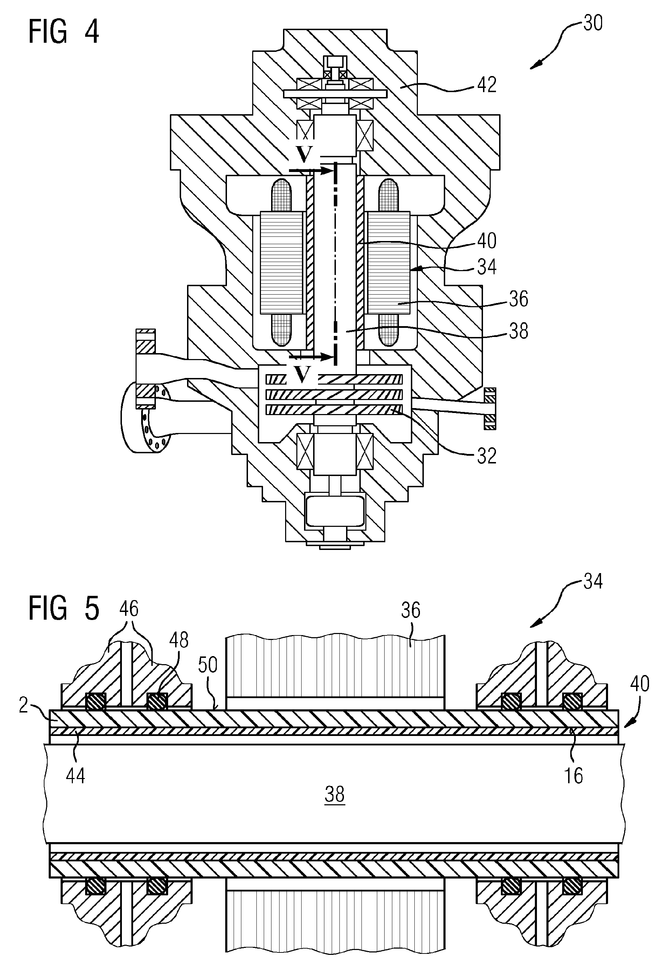

FIG 4 schematically shows a compressor unit 30 comprising a compressor 32 and an electric motor 34 for driving the compressor 32. The electric motor 34 comprises a stator 36 and a rotor 38. Further the compressor unit 30 comprises a can 40, which is arranged between the rotor 38 and the stator 36 of the electric motor 34. Further, the can 40 was produced by one of the methods described in FIG 1 to 3.

The compressor unit 30 comprises a common gas-tight housing 42 for its components 32, 34, 40. Thus, the compressor unit 30 is hermetically sealed.

Further, in FIG 4 a section plane V-V is shown in the form of a dotted line.

FIG 5 shows a detail of the compressor unit 30 of FIG 4 along the section plane V-V. The shown features in FIG 5 are essentially the same as in FIG 4, to which is referred.

The can 40 for an electric motor 34 comprises a hollow cylinder 2 and a coating 44. The inner surface 16 of the hollow cylinder 2 is coated completely by the coating 44. Further, the coating 44 was produced by one of the methods discussed in FIG 1 to 3. The outer surface 50 of the can is uncoated.

The can 40 is placed in an electric motor 34, wherein the electric motor 34 comprises a stator 36 and a rotor 38. The stator 36 and/or the rotor 38 may comprise at least one inductor each (not shown). Further, the electric motor 34 comprises stator walls 46 each comprising a sealing ring 48, which presses against the outer surface 50 of the can 40.

The can 40 prevents gas from the rotor 38 side to reach the stator 36.

The coating 44 of the can 40 is chemically inert. Thus, the coating 44 has a high chemical degradation resistance. For instance, the coating 44 is chemically inert to water moisture, carbon dioxide and hydrogen sulphide. Thus, the coating will enhance the chemical degradation resistance of the can.

Furthermore, the coating 44 is electrically insulating. The electric resistivity of the coating 44 is at least 10⁶ Ωm.

The coating thickness of the coating 44 is 10 µm ± 1 µm. Further, the coating serves as a water barrier.

Moreover, a coefficient of friction (against dry steel) of the coating 44 may be at most 0.3. Further, the coating 44 will enhance the resistance to erosion of the can.

If the coating 44 is a diamond-like carbon coating, a microhardness of the coating 44 is at least 18 GPa and the Rockwell hardness is at least HRC 77. If the coating 44 is a diamond-like hybrid material coating, a microhardness of the coating 44 is at least 8 GPa and the Rockwell hardness is at least HRC 64.

The mentioned microhardness of the coating 44, the mentioned Rockwell hardness of the coating 44 and the mentioned coefficient of friction of the coating 44 result in beneficial erosion properties of the coating 44 and in good anti fouling properties of the coating 44. Thus, the coating 44 minimises erosion of the can 40 caused by particles in the gas and the coating 44 prevents adsorption of the particles at the can 40.

Principally, the hollow cylinder 2 could comprise a second coating on top of the first mentioned coating. The second coating could be produced by one of the methods discussed in FIG 1 to 3.

While specific embodiments have been described in detail, those with ordinary skill in the art will appreciate that various modifications and alternative to those details could be developed in light of the overall teachings of the disclosure. For example, elements described in association with different embodiments may be combined. Accordingly, the particular arrangements disclosed are meant to be illustrative only and should not be construed as limiting the scope of the claims or disclosure, which are to be given the full breadth of the appended claims, and any equivalents thereof.

## Claims

1. Method for producing a can (40) for an electric motor (34),
wherein a hollow cylinder (2) is coated at least partially with a coating (44) by means of a vapour deposition method and wherein the hollow cylinder (2) provided with the coating (44) forms the can (40).

2. Method according to claim 1,
**characterised in that** the hollow cylinder (2) is a composite tube (24) comprising at least one fibre.

3. Method according to claim 1 or 2,
**characterised in that** the coating (44) is chemically inert to water moisture, carbon dioxide and/or hydrogen sulphide.

4. Method according to any of the preceding claims,
**characterised in that** the inner surface (16) of the hollow cylinder (2) is coated completely.

5. Method according to any of the preceding claims,
**characterised in that** the coating (44) is electrically insulating.

6. Method according to any of the preceding claims,
**characterised in that** a coating thickness of the coating (44) is at least 0.2 µm, especially at least 2 µm, and at most 250 µm, especially at most 100 µm.

7. Method according to any of the preceding claims,
**characterised in that** a microhardness of the coating (44) is at least 5 GPa, especially at least 10 GPa, and a coefficient of friction of the coating (44) is at most 0.5, especially at most 0.2.

8. Method according to any of the preceding claims,
**characterised in that** the coating (44) is a diamond-like carbon coating optionally containing a filler, particularly hydrogen.

9. Method according to any of the preceding claims,
**characterised in that** the coating (44) is a diamond-like hybrid material coating containing carbon and a filler, particularly silicon and/or oxide.

10. Method according to any of the preceding claims,
**characterised in that** the coating (44) contains silicon oxide, particularly silicon dioxide.

11. Method according to any of the preceding claims, **characterised in that** the coating (44) contains Parylene.

12. Method according to any of the preceding claims,
**characterised in that** the vapour deposition method is a chemical vapour deposition method, particularly a low pressure chemical vapour deposition method, a plasma enhanced chemical vapour deposition method, an atomic layer deposition method and/or a molecular layer deposition method.

13. Method according to any of the claims 1 to 11,
**characterised in that** the vapour deposition method is a physical vapour deposition method, particularly an evaporative deposition method, a cathodic arc deposition method, a sputter deposition method and/or an ion beam deposition method.

14. Can (40) for an electric motor (34) produced by a method according to any of the preceding claims.

15. Compressor unit (30) comprising a compressor (32),
an electric motor (34) with a stator (36) and a rotor (38) for driving the compressor (32) and a can (40) according to claim 14, wherein the can (40) is arranged between the rotor (38) and the stator (36) of the electric motor (34).
